# EUROPÄISCHE PATENTSCHRIFT

(11) **EP 2 697 827 B1**
(45) Veröffentlichungstag und Bekanntmachung des Hinweises auf die Patenterteilung: **23.03.2016**
(21) Anmeldenummer: 12715017.5
(22) Anmeldetag: 03.04.2012
(51) Int. Cl.: H01L 23/367, H01L 23/373

(54) **KÜHLVORRICHTUNG FÜR EIN ELEKTRONIKMODUL EINES HAUSHALTSGERÄTS SOWIE HAUSHALTSGERÄT MIT EINER KÜHLVORRICHTUNG**
COOLING DEVICE FOR AN ELECTRONIC MODULE OF A HOUSEHOLD APPLIANCE, AND DOMESTIC APPLIANCE COMPRISING A COOLING DEVICE
DISPOSITIF REFROIDISSEUR POUR UN MODULE ÉLECTRONIQUE D'UN APPAREIL ÉLECTROMÉNAGER AINSI QUE APPAREIL ÉLECTROMÉNAGER ÉQUIPÉS D'UN DISPOSITIF REFROIDISSEUR

(30) Priorität: 12.04.2011 DE 102011007171
(43) Veröffentlichungstag der Anmeldung: 19.02.2014
(73) Patentinhaber: BSH Hausgeräte GmbH, 81739 München (DE)
(72) Erfinder: ALBAYRAK, Hasan, Gökcer, 13469 Berlin (DE); MICHAUD, David, Paul, Durham, NC 27713 (US); SEIDL, Rudolf, 93057 Regensburg (DE); SKRIPPEK, Jörg, 14641 Wustermark (DE)
(86) Internationale Anmeldenummer: PCT/EP2012/056082
(87) Internationale Veröffentlichungsnummer: WO 2012/139935

(56) Entgegenhaltungen:
- EP-A2- 2 006 910
- EP-A2- 2 012 355
- WO-A1-2007/037605
- AT-U1- 11 107
- DE-T2- 69 506 957
- US-A- 5 221 575
- US-A- 5 896 269
- US-A1- 2010 132 871

## Beschreibung

Die Erfindung betrifft eine Kühlvorrichtung für ein Elektronikmodul eines Haushaltsgeräts, welche einen Grundkörper aufweist. Des Weiteren betrifft die Erfindung auch eine Baugruppe oder ein Haushaltsgerät, insbesondere zur Pflege von Wäschestücken, mit einer entsprechenden Kühlvorrichtung.

Bei Haushaltsgeräten, wie beispielsweise einem Wäschetrockner oder einer Waschmaschine sind Elektronikbaugruppen vorhanden, die im Betrieb gekühlt werden bzw. deren im Betrieb anfallende Wärme abgeführt werden muss, um die Funktionalität dieser Elektronikbaugruppen durch Überhitzung nicht zu beeinträchtigen. Insbesondere sind hier Antriebsmotoren zu kühlen, die den Antrieb einer Trommel des Haushaltsgeräts bewerkstelligen. Bei herkömmlichen Ausgestaltungen wird vorgesehen, dass ein Kühlkörper aus Aluminium verwendet wird, um die entstehende Wärme abzuführen. Darüber hinaus ist es auch bekannt, dass Lüfter verwendet werden, die durch den erzeugten Luftstrom die Elektronikbaugruppe kühlen sollen.

Diese Ausgestaltungen sind bauraumintensiv und erfordern darüber hinaus auch zusätzliche Bauteile, beispielsweise in Form des Lüfter.

Die US 5 221 575 A offenbart eine Kühlvorrichtung in Form einer thermisch leitendenden Platte für ein Elektronikmodul, mit einer Metallfolie als Grundkörper. Auf der Metallfolie ist ein wärmeableitendes Grafitmaterial eingebettet in SilikonGummi ausgebildet

Die WO 2007/037605 A1 offenbart eine Kühlvorrichtung mit einer Stützstruktur aus Metall, Polymerharz oder Keramik und einer auf deren Oberfläche aufgebrachten ultradünnen anisotropen Grapitschicht.

Die EP 2 006 910 A2 beschreibt ein Trägersubstrat für ein Leistungselektronikmodul mit fest miteinander verbundenen Leistungshalbleitern. Eine Grafit-Folie mit Ausnehmungen für die Leistungshalbleiter ist dabei auf dem Substrat angebracht.

Die US 5 896 269 A zeigt einen Wärmeleitungstreifen zur Verbindung eines wärmeproduzierenden Bauteils, insbesondere eines Prozessors, zu einem Kühlkörper, der eine große Oberfläche bietet und eine Federkraft auf das Bauteil ausübt.

Die EP 1 850 379 A1 offenbart ein metallisches Substrat mit einer organischen Beschichtung, die Graphit enthält. Das Substrat kann einen Grundkörper für eine Kühlvorrichtung bilden der als Gehäuse für ein Elektronikmodul ausgebildet sein kann.

Es ist Aufgabe der vorliegenden Erfindung, eine Kühlvorrichtung für ein Elektronikmodul eines Haushaltsgeräts, sowie eine entsprechende Baugruppe eines Haushaltsgeräts oder ein entsprechendes Haushaltsgerät zu schaffen, mit welcher bzw. mit welchem eine effektivere Kühlung eines Elektronikmoduls erreicht werden kann.

Diese Aufgabe wird durch eine Kühlvorrichtung, welche die Merkmale nach Anspruch 1 aufweist, und ein Haushaltsgerät, welches die Merkmale nach Anspruch 7 aufweist, gelöst.

Eine erfindungsgemäße Kühlvorrichtung für ein Elektronikmodul für ein Haushaltsgerät umfasst einen Grundkörper. Auf dem Grundkörper ist zumindest bereichsweise ein wärmeableitendes Grafitmaterial ausgebildet. Eine derartige Ausgestaltung ermöglicht sehr kompakt und bauraumminimiert eine besonders effektive Kühlung und Wärmeabfuhr vom Elektronikmodul. Unter einem Elektronikmodul werden im Rahmen der Erfindung eine komplette Baugruppe oder einzelne elektronische Bauteile, beispielsweise integrierte Schaltkreise (ICs) oder Transistoren, insbesondere Bipolartransistoren (IGBT), verstanden.

Vorzugsweise ist vorgesehen, dass der Grundkörper aus Kunststoff oder Metall ausgebildet ist. Die Aufbringung des Grafitmaterials ist dadurch besonders gut möglich, insbesondere im Hinblick auf mechanisch stabile Anbringung des Grafitmaterials ist dies vorteilhaft.

Vorzugsweise ist vorgesehen, dass das Grafitmaterial in einer Folie ausgebildet ist, welche auf den Grundkörper aufgebracht, insbesondere aufgeklebt ist. Zum einen ist dies sehr aufwandsarm und kostensparend ermöglicht, zum anderen ist eine derartige Folie auch wieder abnehmbar und ersetzbar, so dass hier auch ein reversibel nachrüstbares System ermöglicht ist, das quasi jederzeit wieder erneuert werden kann.

Vorzugsweise ist vorgesehen, dass der Grundkörper eine Platte ist, und auf beiden Seiten eine Folie mit Grafitmaterial angeordnet ist. Dadurch kann ein besonders guter Wärmeübergang und eine entsprechende Wärmeableitung erzielt werden. Durch diese nahezu vollflächige Bedeckung des plattenförmigen Grundkörpers mit den Folien kann auch eine besonders günstige Verteilung der Wärme auf der Oberfläche erfolgen, so dass eine besonders große Wärmeabfuhr erreicht werden kann.

Es kann vorgesehen sein, dass das Grafitmaterial in einer weiteren Ausführung auch als Pulver auf dem Grundkörper in Form einer Beschichtung aufgebracht ist. Auch hier kann dann sehr ortspezifisch das Grafitmaterial mit entsprechender Schichtdicke individuell aufgebracht werden, so dass auch hier ganz spezifisch den jeweiligen Anforderungen im Hinblick auf die Wärmeabfuhr von dem Elektronikmodul Rechnung getragen werden kann. Auch bei einer derartigen Ausgestaltung kann der Grundkörper aus Kunststoff oder Metall ausgebildet sein.

Vorzugsweise sind in dem mit Grafitpartikeln versetzten Pulver auch weitere Partikel in Form eines Metallmaterials enthalten. Insbesondere sind hier Aluminiumpartikel vorgesehen. Eine derartige Pulvermischung aus Grafit und Aluminium ermöglicht eine besonders effiziente Wärmeabfuhr, gerade dann, wenn der Grundkörper aus Kunststoff ausgebildet ist, gewährleistet eine derartige Beschichtung ein hocheffizientes Kühlen des Elektronikmoduls. Durch die Ausgestaltung des Grundkörpers aus Kunststoff wird dieser auch besonders gewichtsreduziert ausgebildet.

Es kann vorgesehen sein, dass der Grundkörper eine ebene Platte ist.

Insbesondere dann, wenn diese Platte aus einem Metall, insbesondere Aluminium ist, kann darauf entweder eine einseitig oder doppelseitig aufgebrachte Folie aus Grafitmaterial aufgebracht werden oder eine Pulverbeschichtung mit Grafitmaterial aufgebracht werden.

Ist diese ebene Platte aus Kunststoff ausgebildet, kann ebenfalls ein Aufbringen einer Folie mit Grafitmaterial vorgesehen sein. Vorzugsweise ist hier dann eine Pulverbeschichtung mit Grafit- und Aluminiumpartikeln vorgesehen.

Es kann auch vorgesehen sein, dass der Grundkörper eine spezifisch geformte bzw. gebogene Struktur aufweist. Insbesondere ist der Grundkörper eine mäanderförmig ausgebildete und gebogene Platte. Auch diese kann beispielsweise als Blechplatte konzipiert sein und mit einer Folie aus Grafitmaterial bedeckt sein oder mit einer Beschichtung, die Grafitmaterial aufweist, versehen sein.

Besonders vorteilhaft ist es, wenn der Grundkörper eine Gehäusewand des Elektronikmoduls bildet. Dadurch kann somit in multifunktioneller Weise dieser Grundkörper zum einen zum Kühlen des Elektronikmoduls zum anderen zum Umgeben des Elektronikmoduls verwendet werden. Beispielsweise kann hier eine mehrfach gebogene und gewinkelte Formgebung der Platte vorgesehen sein, wobei eine Wand dieser gebogenen Platte dann eine Gehäusewand des Elektronikmoduls darstellt.

Der Grundkörper kann auch eine Gehäusewand eines Gehäuses bilden, welches das Elektronikmodul aufnimmt bzw. umgibt.

Der Grundkörper kann auch, wenigstens teilweise, von einem Bestandteil des Hausgerätes gebildet sein, beispielsweise von einer Gehäusewand oder einem anderen Bauteil; welches in der Lage ist Wärme aufzunehmen und/oder abzuführen.

Wenn der Grundkörper wenigstents teilweise von einer Gehäusewand gebildet wird, können vorteilhaft in dem Haushaltsgerät oder am Elektronikmödul vorhandene, auch größere Massen und Flächen zur Wärmeableitung benutzt werden.

Die Gehäusewand oder das Bauteil des Hausgerätes kann besonders vorteilhaft auch gleichzeitig eine Gehäusewand für das Elektronikmodul bilden. Damit kann Material für das Gehäuse des Elektronikmoduls eingespart werden. Des weiteren kann das Grafitmaterial auf kurzem Wege mit der Gehäusewand oder das Bauteil des Hausgerätes vebunden sein, wodurch der Wärmewiderstand der Kühlvorrichtung weiter verringert ist. Außerdem ist auf diese Weise kein Durchbruch im Gehäuse des Elektronikmoduls zum herausführen des Grafitmaterials, beispielsweise der Grafitfolie erfoderlich.

Wenn das Graphitmaterial als Folie ausgebildet, auf einer Folie ausgebildet oder in eine Folie eingebettet ist, kann es besonders einfach eine flexible wärmeleitfähige Verbindung zum Grundkörper herstellen.

Durch die Kühlvorrichtung kann neben den bereits genannten Vorteilen auch eine bessere Ausnutzung der bestehenden Oberfläche als Wärmetauscher erreicht werden. Eine Verbesserung des Gesamtwirkungsgrades der Wärmeabgabe kann ebenso erreicht werden, wie die Einsparung von zusätzlichen Komponenten, wie beispielsweise des Lüfters. Durch aktiv angebrachte Flächen kann eine hundertprozentige Ausnutzung der vorhandenen Flächen zum Wärmeabtransport gewährleistet werden.

Des Weiteren betrifft die Erfindung eine Baugruppe umfassend ein Elektronikmodul und eine Kühlvorrichtung, welche im innigen Kontakt zum Elektronikmodul steht, wobei die Kühlvorrichtung mit den Merkmalen der erfindungsgemäßen Kühlvorrichtung oder einer vorteilhaften Ausgestaltung davon ausgeführt ist.

Die Erfindung betrifft ferner ein Haushaltsgerät, insbesondere zur Pflege von Wäschestücken, wie beispielsweise eine Waschmaschine oder einen Wäschetrockner oder einem Waschtrockner, welches eine erfindungsgemäße Kühlvorrichtung, eine vorteilhafte Ausgestaltung davon oder eine Baugruppe mit der erfindungsgemäßen Kühlvorrichtung aufweist.

Die Merkmale der vorteilhaften Ausgestaltungen der erfindungsgemäßen Kühlvorrichtung können im Rahmen der Erfindung in beliebiger Kombination miteinander oder Bestandteil der Baugruppe bzw. des Haushaltsgerät sein.

Insbesondere ist das Elektronikmodul oder die Baugruppe mit einem solchen Elektronikmodul eine Antriebselektronik zum Antreiben einer Trommel des Haushaltesgeräts. In dieser Trommel können Wäschestücke zum Waschen oder Trocknen aufgenommen werden.

Ausführungsbeispiele der Erfindung werden nachfolgend anhand schematischer Zeichnungen näher erläutert. Es zeigt:
- Fig. 1: eine erstes Ausführungsbeispiel einer Kühlvorrichtung;
- Fig. 2: ein zweites Ausführungsbeispiel einer Kühlvorrichtung;
- Fig. 3: ein drittes Ausführungsbeispiel einer Kühlvorrichtung;
- Fig. 4: ein viertes Ausführungsbeispiel einer Kühlvorrichtung; und
- Fig. 5: ein fünftes Ausführungsbeispiel einer Kühlvorrichtung.

In den Figuren werden gleiche oder funktionsgleiche Elemente mit den gleichen Bezugszeichen versehen.

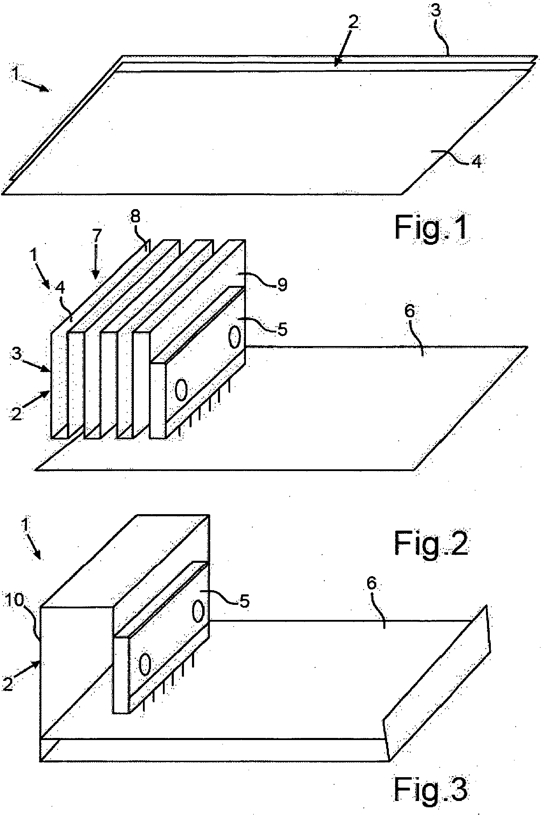

In Fig. 1 ist in einer schematischen perspektivischen Darstellung ein erstes Ausführungsbeispiel einer Kühlvorrichtung 1 gezeigt. Die Kühlvorrichtung 1 ist thermisch mit einem nicht dargestellten Elektronikmodul eines Wäschetrockners oder einer Waschmaschine gekoppelt. Das Elektronikmodul ist insbesondere eine Antriebselektronik zum Antreiben einer Wäschetrommel.

Die Kühlvorrichtung 1 ist somit im Inneren des Haushaltsgeräts angeordnet. Die Kühlvorrichtung 1 weist in der gezeigten Ausführung einen Grundkörper 2 auf, der als ebene Platte ausgebildet ist. Dieser Grundkörper 2 ist im Ausführungsbeispiel ein Metallblech, beispielsweise aus Aluminium. Wie zu erkennen ist, wird auf beiden Oberflächen dieses Grundkörpers 2 jeweils eine Folie 3 und 4 aufgeklebt. Die Folien 3 und 4 sind aus Grafitmaterial ausgebildet. Wie zu erkennen ist, ist der Grundkörper 2 an seinen gegenüberliegenden Oberflächen vollflächig durch die Folien 3 und 4 bedeckt.

In Fig. 2 ist in einer weiteren schematischen perspektivischen Darstellung ein weiteres Ausführungsbeispiel einer Kühlvorrichtung 1 gezeigt. Hier ist zusätzlich das Elektronikmodul 5 gezeigt, welches auf einer Leiterplatte 6 angeordnet ist. In der hier gezeigten Ausführung ist der Grundkörper 2 wiederum eine Platte, die mehrfach gebogen ist und eine Mäanderform aufweist. Diese Platte in Form des Grundkörpers 2 ist wiederum beispielhaft als Metallblech, beispielsweise aus Aluminium ausgebildet. Auch hier kann dann einerseits vorgesehen sein, dass dieser Grundkörper 2 auf allen Oberflächen und somit auch wieder doppelseitig mit einer Folie 3 und einer Folie 4 aus Grafitmaterial beklebt ist.

Ebenso kann vorgesehen sein, dass anstelle der Folien 3 und 4 beidseitig ausgebildete Beschichtungen 7 und 8 aufgebracht sind, welche Grafitpartikel aufweisen, insbesondere im wesentlichen ausschließlich aus Grafitpartikeln bestehen.

Wie zu erkennen ist, ist das Elektronikmodul 5 mit einer Teilwand 9 des Grundkörpers 2 großflächig direkt kontaktiert, so dass die im Betrieb des Elektronikmoduls 5 entstehende Wärme großflächig an das wärmeableitende Grafitmaterial der Kühlvorrichtung 1 abgegeben werden kann.

In Fig. 3 ist in einer weiteren vereinfachten schematischen Darstellung ein weiteres Ausführungsbeispiel einer Kühlvorrichtung 1 gezeigt. Hier ist vorgesehen, dass der Grundkörper 2 mit einer Teilwand 10 zugleich eine Gehäusewand eines Gehäuses bildet, welches das Elektronikmodul 5 und die Leiterplatte 6 aufnimmt bzw. umgibt. Im Hinblick auf die materielle Ausgestaltung des Grundkörpers 2 als auch im Hinblick auf die Optionen, wie das Grafitmaterial auf dem Grundkörper 2 aufgebracht ist, wird auf die bereits erläuterten Ausführungen in Fig. 1 und Fig. 2 verwiesen.

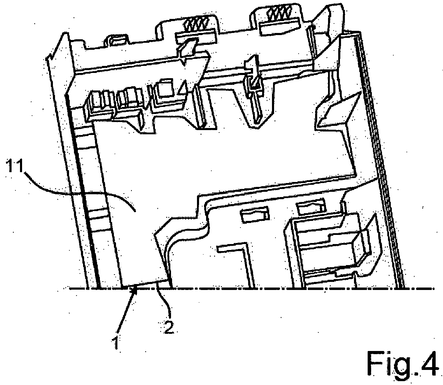

In Fig. 4 ist in einer weiteren perspektivischen Teildarstellung ein weiteres Ausführungsbeispiel für eine Kühlvorrichtung 1 gezeigt. Hier ist der Grundkörper 2 aus Kunststoff ausgebildet. Dieser Grundkörper 2 ist dann mit einem Pulver 11 beschichtet, welches sowohl Grafitpartikel als auch Aluminiumpartikel als Pulver aufweist. Auch hier kann vorgesehen sein, dass der Grundkörper 2 zumindest bereichsweise eine Gehäusewand für ein Gehäuse eines nicht dargestellten Elektronikmoduls bildet.

Ebenso kann vorgesehen sein, dass der Grundkörper 2 aus einem Gemisch des Kunststoffmaterials, des Aluminiummaterials und des Grafitpulvergranulats komplett beschichtet, bzw. andererseits auch vollständig gegossen ist.

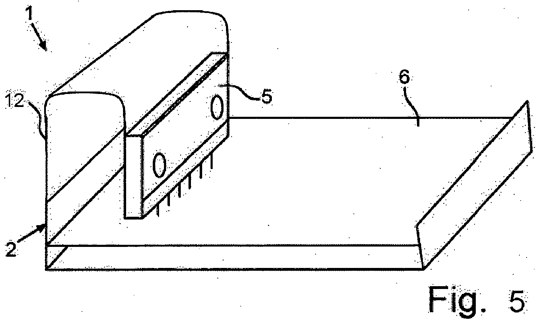

In Fig.5 ist in einer weiteren, vereinfachten schematischen Darstellung ein weiteres Ausführungsbeispiel einer Kühlvorrichtung 1 gezeigt. Auch hier ist vorgesehen, dass der Grundkörper 2 zugleich eine Gehäusewand eines Gehäuses bildet. Das Gehäuse kann ein Gehäuse für das Elektronikmodul 5 sein, welches das Elektronikmodul 5 und die Leiterplatte 6 aufnimmt bzw. umgibt. Alternativ kann die Gehäusewand auch von einer Gehäusewand oder einem anderen Bauteil eines hier nicht weiter dargestellten Haushaltsgerätes gebildet sein. Das Grafitmaterial ist in dieser Ausführung in Form einer flexiblen Folie 12 ausgebildet. Die Grafitfolie 12 ist auf dem Grundkörper 2, aufgebracht, beispielsweise aufgeklebt. Die Grafitfolie 12 ist auch mit dem Elektronikmodul 5 verbunden, beispielsweise aufgeklebt und stellt damit eine wärmeleitende Verbindung vom Elektronikmodul 5 zum Grundkörper her. Das Elektronikmodul 5 ist hier nur schematisch vereinfacht dargestellt und kann im Rahmen der Erfindung eine komplette Baugruppe oder einzelne elektronische Bauteile, beispielsweise integrierte Schaltkreise (ICs) oder Transistoren, insbesondere Bipolartransistoren (IGBT), umfassen.

### Bezugszeichenliste

- 1: Kühlvorrichtung
- 2: Grundkörper
- 3,4: Folie
- 5: Elektronikmodul
- 6: Leiterplatte
- 7,8: Beschichtung
- 9, 10: Teilwand
- 11: Pulver

## Patentansprüche

1. Kühlvorrichtung (1) für ein Elektronikmodul (5) eines Haushaltsgeräts, welche einen Grundkörper (2) aufweist, auf dem zumindest bereichsweise ein Wärme ableitendes Grafitmaterial ausgebildet ist, wobei der Grundkörper (2) eine Gehäusewand eines Gehäuses bildet, welches das Elektronikmodul (5) aufnimmt bzw, umgibt, **dadurch gekennzeichnet, dass** das Grafltma terial als Pulverbeschichtung (11) auf einen Grundkörper (2) aus Kunststoff aufgebracht ist .

2. Kühlvorrichtung (1) nach Anspruch 1, **dadurch gekennzeichnet, dass** in dem Pulver (11) Metallmaterial enthalten ist.

3. Kühlvorrichtung (1) nach Anspruch 1, **dadurch gekennzeichnet, dass** in dem Pulver (11) Aluminiummaterial, enthalten ist.

4. Kühlvorrichtung (1) nach einem der vorhergehenden Ansprüche, **dadurch gekennzeichnet, dass** der Grundkörper (2) eine ebene Platte ist.

5. Kühlvorrichtung (1) nach einem der Ansprüche 1 bis 3, **dadurch gekennzeichnet, dass** der Grundkörper (2) eine mäanderförmig gebogene Platte ist.

6. Kühlvorrichtung (1) nach einem der vorhergehenden Ansprüche, **dadurch gekennzeichnet, dass** der Grundkörper (2) eine Gehäusewand eines Gehäuses des Elektronikmoduls (5) ist.

7. Haushaltsgerät, mit einer Kühlvorrichtung (1) nach einem der Ansprüche 1 bis 5.

8. Haushaltsgerät nach Anspruch 7, bei dem der Grundkörper von einer Gehäusewand des Haushaltsgerätes gebildet ist

## Claims

1. Cooling device (1) for an electronic module (5) of a domestic appliance, which cooling device (1) has a base body (2), on which a heat-dissipating graphite material is embodied at least in regions, wherein the base body (2) forms a housing wall of a housing which accommodates or encases the electronic module (5), **characterised in that** the graphite material is applied to a base body (2) made of plastic as a powder coating (11).

2. Cooling device (1) according to claim 1, **characterised in that** metal material is contained in the powder (11).

3. Cooling device (1) according to claim 1, **characterised in that** aluminium material is contained in the powder (11).

4. Cooling device (1) according to one of the preceding claims, **characterised in that** the base body (2) is a flat plate.

5. Cooling device (1) according to one of claims 1 to 3, **characterised in that** the base body (2) is a plate curved in a serpentine manner.

6. Cooling device (1) according to one of the preceding claims, **characterised in that** the base body (2) is a housing wall of a housing of an electronic module (5).

7. Domestic appliance, with a cooling device (1) according to one of claims 1 to 5.

8. Domestic appliance according to claim 7, in which the base body is formed by a housing wall of the domestic appliance.

## Revendications

1. Dispositif de refroidissement (1) pour un module électronique (5) d'un appareil ménager, présentant un corps de base (2), sur lequel un matériau graphitique évacuant la chaleur est au moins exécuté par zones, dans lequel le corps de base (2) constitue une paroi de bâti d'un bâti qui accueille resp. entoure le module électronique (5), **caractérisé en ce que** le matériau graphitique est appliqué sous forme de revêtement poudré (11) sur un corps de base (2) en plastique.

2. Dispositif de refroidissement (1) selon la revendication 1, **caractérisé en ce que** la poudre (11) contient un matériau métallique.

3. Dispositif de refroidissement (1) selon la revendication 1, **caractérisé en ce que** la poudre (11) contient un matériau en aluminium.

4. Dispositif de refroidissement (1) selon l'une des revendications précédentes, **caractérisé en ce que** le corps de base (2) est une plaque plane.

5. Dispositif de refroidissement (1) selon l'une des revendications 1 à 3, **caractérisé en ce que** le corps de base (2) est une plaque pliée afin de décrire des méandres.

6. Dispositif de refroidissement (1) selon l'une des revendications précédentes, **caractérisé en ce que** le corps de base (2) est une paroi de bâti d'un bâti du module électronique (5).

7. Appareil ménager avec un dispositif de refroidissement (1) selon l'une des revendications 1 à 5.

8. Appareil ménager selon la revendication 7, dans lequel le corps de base est constitué par une paroi de bâti de l'appareil ménager.
